# EUROPEAN PATENT APPLICATION

(11) **EP 4 239 675 A1**
(43) Date of publication of application: **06.09.2023**
(21) Application number: 22159808.9
(22) Date of filing: 02.03.2022
(51) Int. Cl.: H01L 23/544, H01L 21/66

(54) **SEMICONDUCTOR WAFER WITH ALIGNMENT MARK INDICATING THE WAFER ORIENTATION AND METHOD FOR FABRICATING SAID SEMICONDUCTOR WAFER**

(71) Applicant: Infineon Technologies Austria AG, 9500 Villach (AT)
(72) Inventor: KLEINBICHLER, Andreas, 9500 Villach (AT); MAURER, Daniel, 9544 Feld am See (AT); ORTNER, Joerg, 9580 Drobollach (AT); ROTHMALER, Rudolf, 9500 Villach (AT)
(74) Representative: JENSEN & SON

(57) **Abstract**

In an embodiment, a semiconductor wafer (10) comprises a front surface (11), a plurality of active component positions (12) and at least one composite alignment mark (14) arranged on the front surface (11) and indicating a unique orientation of the semiconductor wafer (10). The composite alignment mark (14) comprises a first portion (17) that comprises at least one raised section (20, 24) formed of a first material and a second portion (18) that is positioned laterally adjacent the first portion (17). The second portion (18) comprises at least one raised section (25, 26) formed of a second material that is different form the first material.

## Description

### BACKGROUND

The invention relates to a semiconductor wafer, in particular a semiconductor wafer with at least one alignment mark and to a method of fabricating a semiconductor wafer, in particular, a semiconductor wafer including at least one alignment mark.

Semiconductor devices are typically formed in a semiconductor wafer, whereby the semiconductor wafer can include hundreds or thousands of devices which are typically arranged in regular array of rows and columns and spaced apart by a kerf region to designate a component position. A kerf region is also referred to as a scribe line region, saw street, dicing street or singulation region. The wafer is singulated along the kerf region to form individual semiconductor dies, each including one or more devices, from the wafer. During wafer manufacturing, the wafer is placed into different types of tools and apparatus for carrying out one or more of the processes to fabricate the semiconductor devices. It is, therefore, desirable to be able to align the semiconductor wafer in a particular position. One or more alignment marks or structures are typically provided on the front surface of the wafer to allow its alignment in a particular position.

During the final stages of wafer manufacturing, tests for process control monitoring are carried out on auxiliary structures and/or the semiconductor devices before the wafer is diced to form individual semiconductor dies. it is desirable that the wafer has a known alignment such that the probing needles can be accurately placed on these structures positioned in the wafer. US 2001/0242148 A1 discloses a semiconductor substrate having an at least one alignment pad for optical process control for semiconductor wafer probing.

Further improvements for aligning semiconductor wafers are, however, desirable.

### SUMMARY

According to the invention, a semiconductor wafer is provided which comprises a front surface, a plurality of active component positions and at least one alignment mark which is arranged on the front surface and which indicates a unique orientation of the semiconductor wafer. The alignment mark is a composite alignment mark that comprises a first portion that comprises at least one raised section formed of a first material and a second portion that is positioned laterally adjacent the first portion and that comprises at least one raised section formed of a second material that is different from the first material.

The unique orientation defines a particular orientation of the wafer in three-dimensional space that is the only one of its kind.

The composite alignment mark on the wafer is used to position the wafer, typically relative to a tool. This positioning is called "alignment". Therefore, the composite alignment mark on the wafer assists in alignment of the wafer and a tool relative to one another and itself also carries information about the orientation of the wafer in three-dimensional space, in particular indicates a unique orientation of the wafer in three-dimensional space.

The term "orientation" of the wafer describes the orientation of the wafer that is typically performed using a notch or flat edge on the wafer. This orientation is taken care of by the wafer loader and a notch finder, for example, upon wafer loading into the tool. The wafer is then loaded with correct orientation, e.g. notch down, onto a tool chuck, where the further processing is done. The tool will then look for the composite alignment mark on the wafer, align the wafer so as to get the x/y coordinates of the wafer correct and start working. For example, the tool may be a wafer tester.

The composite alignment mark is formed of two portions formed of differing materials which are positioned laterally adjacent to one another. In some embodiments, one or both of the first and second portion have a shape or contour in top view, that is when observing the front surface of the semiconductor wafer, which indicates a unique orientation of the semiconductor wafer. In some embodiments, the first and second portion of the composite alignment mark together indicate a unique orientation of the semiconductor wafer. The composite alignment mark is used to align the wafer relative to another object, such as a tool used in the final manufacturing processes, for process control monitoring and so on.

One or both of the first and second portion may be formed of one or more sections that may be laterally spaced apart from one another. One or more of the sections of one or both of the first and second portions may itself indicate the unique orientation of the semiconductor wafer.

The use of two portions formed from differing materials enables the materials to be selected such that there is sufficient optical contrast between the portions to use the composite alignment mark to align the wafer relative to a tool. This is useful if at least one of the portions is formed from a layer that has insufficient optical contrast over the underlying surface of the semiconductor wafer.

An alignment mark is generally required for process control monitoring (PCM) automatization. Whilst orientation for process control monitoring may be carried out using the wafer as the orientation structure, i.e. a flat or notch in the wafer is used to orient the wafer in a known orientation, the alignment of the wafer in the x-y plane achieved by the flat of notch in the wafer may not be precise enough to align probe needles centered on PCM pads as wafer loading is commonly more inaccurate than the size of a typical pad.

After wafer loading, the composite alignment mark is used for alignment of the wafer relative to the tool and, for example, may be used to ensure the correct chip is measured. If during die attach picks a wrong die is removed from the singulated wafer, a "bad" die could be removed in place of the correct "good" die. The composite alignment mark assists in assigning the previously determined emap correctly to the real wafer grid and avoiding picking wrong die or avoiding issues with shifted die grids upon processing the wafers.

The one or more composite alignment marks can be visualized optically, for example by the bare eye, or by use of a light microscope or automatically by optical measuring tools or alignment cameras as used in various semiconductor manufacturing tools.

In some embodiments, the one or more composite alignment marks are formed in a layer or layers that also form part of the metallization structure of the active devices formed in the wafer, for example in a AlCu layer or interlayer dielectric layer, by photolithographic structuring of the layer(s). Structuring of the composite alignment mark can be done as part of the lithography step for a device layer or in a separate lithography step. A composite alignment mark may be placed on a minimum of 2 positions or 4 or more positions on the wafer depending on the wafer size and chip size. Larger wafers and smaller chips typically benefit from more marks for alignment. The subsequent process steps in the photolithography are the same so that chip design and alignment marks can be structured within the same process.

The portion or a section of the portion of the alignment mark formed from a metal or alloy can itself have a form indicating a unique orientation of the wafer and can be used for alignment before the fabrication of the second portion, for example, before the deposition of an electrically insulating layer, for example polyimide, that covers the scribe line regions and peripheral regions of the singulated chips or dies.

For example, the first portion of the composite alignment mark can be formed in copper and this used for referencing at wafer test. Subsequently, the passivation process is performed and the second portion of the composite alignment mark is formed, for example printed. The subsequent die pickup process then aligns on the composite mark and benefits from the enhanced contrast of the composite mark.

The composite alignment marks including the first and second portions of differing materials may be used subsequent to wafer fabrication, for example by the customer of a wafer, for wafer alignment before and during singulation of the dies from the wafer and/or at or before die pickup.

In some embodiments, the first and second portions have complementary shapes. Herein the term complementary shape indicates that one of the portions has the inverse shape of the other, for example has the negative of the positive shape of the other portion.

The first and second portion may have the inverse or complementary shapes and inverse topology. The first portion may have inverse topology to the subsequent second portion formed in, for example, polyimide, which can be structured via full mask or via reticle. This is designed in order to provide contrast for so called back-end processes where 7-crosses of Imide are used for wafer alignment during wafer dicing and pick and place of the dies separated from the wafer. The resulting structure is a stacked layer combination of metal and Imide.

In some embodiments, the composite alignment mark is rotationally asymmetric about an axis that extends orthogonally to the front surface of the wafer. In some embodiments, both the first portion and the second portion are each rotationally asymmetric. In some embodiments, one or more of the raised sections of the first portion and/or one or more raised sections of the second portion may be are rotationally asymmetric with respect to the axis which extends perpendicular to the front surface of the semiconductor wafer and a further one or more raised sections or the first portion and/or second portion are rotationally symmetric. For example, the first portion or the second portion may include a raised section which has the form of a square border or square frame, which is rotationally symmetric about the axis which extends perpendicular to the front surface of the wafer, and a further raised section arranged in and laterally surrounded by the frame which has the form of a 7-cross which is rotationally asymmetric about the axis which extends perpendicular to the front surface of the wafer.

The use of a frame, for example a square frame, rectangular frame or circular frame may be used to provide height alignment of the semiconductor wafer. For example, the lateral size of the frame can be determined, for example using optical recognition methods, and compared with the known size of the frame at the desired height. Differences in the measured size from the known size may be used to adjust the height of the wafer so that the wafer is positioned at the desired height.

In some embodiments, a first raised section of the first portion has the form of a closed border or closed frame. In some embodiments, the first raised section of the first portion has the form of a frame that laterally surrounds and is laterally spaced apart from a second raised section of the first portion, whereby the second raised section is rotationally asymmetric and indicates the unique orientation of the semiconductor wafer.

In some embodiments, the second portion and also the at least one raised section of the second portion have a height which is greater than the height of the first portion and the at least one raised section of the first portion.

In some embodiments, the second portion of the composite alignment mark is contiguous with the first portion of the composite alignment mark. The raised sections of the first portion and the second portion each have side faces which protrude from the front surface of the wafer. The side faces of the second portion are in contact with the side faces of the first portion so that the second portion is contiguous with the first portion. In some embodiments, the side faces extend substantially perpendicularly to the front surface of the wafer and in other embodiments an at inclined angle to the front surface of the wafer. For example, if the portion is formed by wet chemical etching, the side faces may extend at an inclined angle to the front surface, e.g. 45°, or have a curved form due to underetching.

In some embodiments, the second portion of the composite alignment mark overlaps the periphery of the first portion. For example, the second portion may overlap a peripheral region of the first portion, whereby the overlap has a width which is between 1 % and 20%, for example 10%, of the width of the first portion. The remainder of the first portion is uncovered by the second portion.

In some embodiments, the second portion is spaced apart a distance from the first portion. The second portion is then spaced apart by a gap from the first portion. The gap may have a width which is between 1% and 20%, for example 10%, of the width of the first portion.

In some embodiments, the raised section(s) of the second portion of the composite alignment mark are contiguous with the raised section(s) of the first portion of the composite alignment mark such that the side faces of the sections of the second portion are in contact with the side faces of the sections of the first portion.

In some embodiments, the raised section of the second portion of the composite alignment mark overlaps the periphery of the raised section of the first portion. For example, one raised section of the second portion may overlap a peripheral region of a raised section of the first portion, whereby the overlap has a width which is between 1 % and 20%, for example 10%, of the width of the raised section of the first portion. The remainder of the raised section of the first portion is uncovered by the raised section of the second portion.

In some embodiments, the raised section of the second portion is spaced apart a distance from the raised section of the first portion by a gap. The gap may have a width which is between 1% and 20%, for example 10%, of the width of the raised section of the first portion.

At least one composite alignment mark may be located in various positions on the front surface of the wafer. In some embodiments, at least one composite alignment mark is positioned in an inactive portion of the wafer, outside of the plurality of active component positions, for example, in a peripheral region of the front surface of the semiconductor wafer. At least one composite alignment mark may be positioned in a scribe region, that is arranged laterally adjacent one of the active component positions. This scribe region is also known as the kerf region, saw street or dicing street. At least one composite alignment mark may be located in a dummy component position. A dummy component position may include an auxiliary or test structure, for example. In some embodiments, the alignment mark may be created on top of a die or onto a large contact pad, e.g. a large aluminium pad.

Typically, two or more, for example four, composite alignment marks are positioned on the front surface of the semiconductor wafer. The number of composite alignment marks and their particular location as well as the distribution of the composite alignment marks over the front surface of the wafer may be selected depending on the size of the wafer, the size of the active component positions and, therefore, the number of active component positions within the semiconductor wafer as well as the size of the features of the active component positions and/or test structures. For example, for small semiconductor devices which have small structures or small contact pads, a more accurate alignment is desirable compared to larger semiconductor devices which have larger contact pads. Therefore, the number of composite alignment marks used for a wafer comprising small semiconductor devices may be larger than that used for a wafer comprising large semiconductor devices.

A larger number of marks which are, for example, distributed across the entire wafer is useful in a situation in which the wafers are loaded and unloaded several times in one backend tool, for example so that the wafer can be rotated 180° and reloaded into the tool so that after reloading the wafer has to be realigned relative to the tool.

In some embodiments, the location of the composite alignment marks is selected such that during pick and place of the dies from the singulated wafer, a composite alignment mark is detected after a predetermined number of dies to allow the re-determination of the alignment of the wafer and realignment of the wafer, if necessary, before pick and place continues. This may be useful for small dies and/or wafer including a large number of dies.

In some embodiments, each active component position may include a semiconductor device, for example a transistor device, a diode, or more than one semiconductor device, for example, two transistor devices, or a transistor device and a diode. In embodiments in which each active component position comprises more than one semiconductor device, the semiconductor devices within each active component position may be electrically coupled to form a particular circuit. For example, the case of two transistor devices, the transistor devices may be electrically connected to form half bridge circuit, for example by means of the metallisation structure formed on the front surface and/or the opposing rear surface of the semiconductor wafer.

In some embodiments, a metallisation structure is formed on the front surface of the semiconductor wafer in each of the active component positions which forms the frontside metallization and contact pads for each die after singulation. The metallisation structure includes one or more electrically conductive layers and one or more electrically insulating layers. The first portion of the composite alignment mark may be formed from one or more of the electrically conductive layers of the metallisation structure.

In some embodiments, the first material of the first portion comprises a metal or an alloy. In some embodiments, the first material comprises aluminium or copper or is formed of an aluminium copper alloy. In other embodiments, the first material comprises gold, tungsten, tungsten alloy, titanium and/or titanium nitride. In some embodiments, the first material may be formed of the metal or alloy or combination of metals and alloys used to form the frontside metallisation structure of the devices formed in the active component positions.

In some embodiments, the first material is formed of a stack of sublayers of metals or alloys, for example corresponding to the stack or a substack of metals and alloys used for the frontside metallization. For example, the first material and the first portion may include a stack of Ti, TiN and AlCu.

In some embodiments, the second material of the second portion comprises an electrically insulating material. In some embodiments, the electrically insulating material comprises an imide, for example polyimide, an epoxy, a nitride, for example silicon nitride, an oxide, for example silicon oxide or may include a multilayer structure, for example a multilayer nitride oxide structure, for example a silicon nitride layer with a silicon oxide layer on the silicon nitride layer. The electrically insulating layer used for the composite alignment mark may be the same as the electrically insulating layer material used to form one or more of the interlayer dielectric layers of the frontside metallisation structure of the active component positions.

In some embodiments, the active component positions each comprise a transistor device and the first portion of the composite alignment mark is formed in the same metallisation layer as a layer of the source pad and/or in the same electrically conductive metallisation layer as a layer of the gate pad and the second portion of the composite alignment mark Alu is formed in an electrically insulating layer arranged on the front surface of the active component positions of the semiconductor wafer. In some embodiments, the electrically insulating layer is the uppermost electrically insulating layer of the metallisation structure. The electrically insulating layer or layers may extend throughout the scribe line regions that are positioned adjacent and/or between active component positions.

In some embodiments, the source pad and the gate pad comprise a plurality of metallic sublayers. The first portion of the composite alignment mark may be formed from all or some of the plurality of metallic sublayers.

According to the invention, a method of fabricating a semiconductor wafer is provided, the method comprising depositing a first layer of the first material on to a front surface of a semiconductor wafer, whereby the semiconductor wafer comprises a plurality of active component positions. Each of the active component positions may include device structures within the semiconductor material of the wafer. The method further comprises forming a first portion of at least one composite alignment mark in the first layer. The first portion of at least one composite alignment mark has at least one raised section formed of the first material. In some embodiments, the first portion indicates a unique orientation of the wafer. A second layer is deposited onto the first layer, the second layer comprising a second material that differs from the first material. The second layer is structured to form a second portion of the composite alignment mark. The second portion comprises at least one raised section formed of the second material. The second layer is structured to expose at least a part of the raised section formed of the first material, thus forming the composite alignment mark indicating the unique orientation of the wafer.

This method may be used to fabricate a composite alignment mark according to any one of the embodiments described herein.

In some embodiments, the forming the first portion of at least one composite alignment mark in the first layer comprises structuring the first layer by laser ablation to form the at least one raised section formed of the first material. In this embodiment, laser ablation is used to remove portions of the first layer such that the remaining portions of the first layer form the at least one raised section formed of the first material. In some embodiments, etching is used to remove portions of the first layer such that the remaining portions of the first layer form the at least one raised section formed of the first material. Wet chemical etching or dry etching such as plasma etching may be used. Alternatively, the first material may be selectively deposited to form the at least one raised section formed of the first material.

In some embodiments, the structuring the second portion of at least one composite alignment mark in the first layer comprises structuring the second layer by laser ablation to form the at least one raised section formed of the second material. In this embodiment, laser ablation is used to remove portions of the second layer such that the sections of the first layer forming the at least one raised section formed of the first material are at least partially exposed. In sone embodiments, etching is used to remove portions of the first layer such that the remaining portions of the first layer form the at least one raised section formed of the first material. Wet chemical etching or dry etching such as plasma etching may be used.

The first and second layer may be structured using photolithographic methods and may be structures using the same masks as the metallization structure and/or in additional steps with additional masks.

In some embodiments, the method further comprises further structuring the first layer to form a gate pad and/or a source pad in the active component positions and further structuring the second layer to expose the gate pad and/or source pad. In these embodiments, the first layer and the second layer are formed on the plurality of active component positions and may also be formed at on the inactive portion of the wafer outside of the plurality of component positions, on the scribe line regions that are positioned adjacent between the active component positions and in a dummy component position. Thus, one or more composite alignment mark may be formed in an active portion of the wafer outside of the plurality of active component positions and/or the scribe line region that is adjacent one of the active component positions or between neighbouring active component positions and/or in a dummy component position of the semiconductor wafer.

In some embodiments, a metallisation structure is formed on the front surface of the semiconductor wafer in each of the active component positions. The metallisation structure includes one or more electrically conductive metallisation layers and one or more electrically insulating layers.

The first layer may comprise a metal or alloy and form part of the can electrically conductive redistribution structure provided by the metallisation structure formed in the active component positions. The second layer may comprise an electrically insulating material which forms part of the electrically insulating structure of the metallisation structure formed in the active component positions, for example, forms an interlayer dielectric layer, of the metallisation structure, for example, an uppermost electrically insulating layer of the metallisation structure or a passivation layer.

In some embodiments, the first material of the first portion comprises a metal or an alloy. In some embodiments, the first material comprises aluminium or copper or is formed of an aluminium copper alloy. In other embodiments, the first material comprises gold, tungsten, tungsten alloy, titanium and/or titanium nitride. For example, the first material may be formed of the metal or alloy or combination of metals and alloys used to form the frontside metallisation structure of the devices formed in the active component positions.

In some embodiments, the second material of the second portion comprises an electrically insulating material. In some embodiments, the electrically insulating material comprises an imide, for example polyimide, an epoxy, a nitride, for example silicon nitride, an oxide, for example silicon oxide or may include a multilayer structure, for example a multilayer nitride oxide structure, for example a silicon nitride layer with a silicon oxide layer on the silicon nitride layer. The electrically insulating layer used may be the same as the electrically insulating layer material used to form one or more of the interlayer dielectric layers of the frontside metallisation structure of the active component positions.

In some embodiments, the method further comprises testing one or more parameters of a device that is positioned in one of the active component positions and/or testing one or more parameters of an auxiliary device that is positioned in a dummy component position and/or testing one or more parameters of an auxiliary device that is positioned in a scribe line region.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a schematic top view of a front side of a semiconductor wafer according to an embodiment.
Figure 2A illustrates a cross-sectional view and figure 2B a top view of a composite alignment mark according to an embodiment.
Figure 3A illustrates a cross-sectional view and figure 3B a top view of a composite alignment mark according to an embodiment.
Figure 4 illustrates a cross-sectional view of a composite alignment mark according to an embodiment.
Figure 5A illustrates a cross-sectional view and figure 5B a top view of a first portion of an alignment mark and figure 5C and figure 5D illustrates a cross-sectional view and top view, respectively, of the alignment mark after fabrication of the second portion of the composite alignment mark.
Figure 6 illustrates a cross-sectional view of a semiconductor wafer according to an embodiment.
Figure 7 illustrates a flow diagram of a method of fabricating a composite alignment mark on the front surface of a semiconductor wafer.
Figure 8 illustrates a flow diagram of a method for fabricating a semiconductor wafer.
Figure 9 illustrates a flow diagram of a method for fabricating a semiconductor component.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

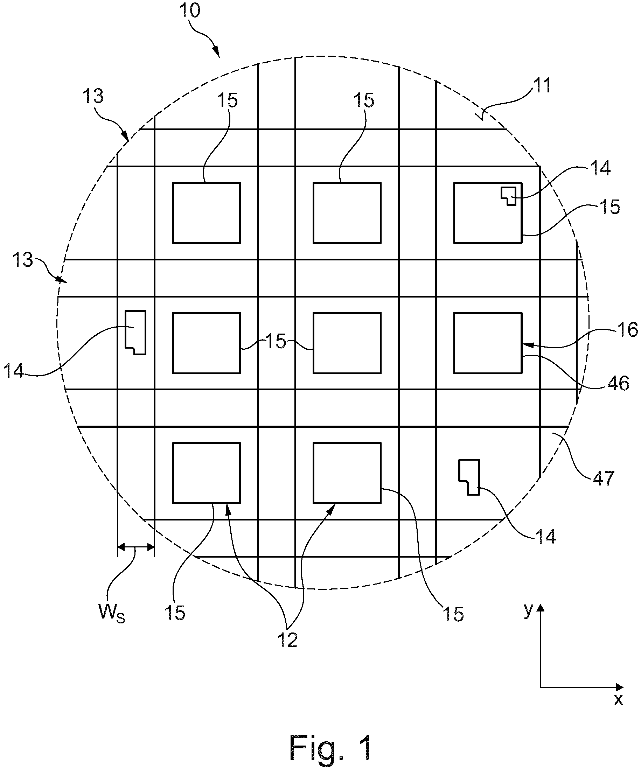

Figure 1 illustrates a schematic view of a semiconductor wafer 10 according to an embodiment. the semiconductor wafer 10 comprises a front surface 11 and a plurality of active component positions 12 which are arranged in a regular array of rows and columns whereby a scribe line region 13 having a width wₛ is arranged laterally adjacent and between neighbouring ones of the active component positions 12. A plurality of the scribe lines 13 extend parallel to one another in the Y direction and a further plurality of the scribe lines 13 parallel to one another in the X direction to form a grid. The semiconductor wafer 10 may be formed of monocrystalline silicon or may comprise an epitaxial silicon layer formed on a monocrystalline substrate.

The semiconductor wafer 10 further comprises at least one composite alignment mark 14 arranged on the front surface 11 of the semiconductor wafer 10. The active component positions 12 each include a semiconductor device which is indicated schematically in figure 1 by the box 15. The active component positions 12 include device structures formed in the semiconductor material of the wafer 10 and may also include a metallisation structure arranged on the front surface 11 of the semiconductor wafer 10 in the active component positions 12, which are not illustrated in the schematically of figure 1. For example, the device may be a transistor device or a diode. In some embodiments, each component position includes more than one semiconductor device, for example a transistor and diode, whereby the two or more devices may be electrically coupled to one another to form a desired circuit.

The semiconductor wafer 10 may also include one or more dummy positions 16 which include an auxiliary or test device 46 which may be used for device testing or process control monitoring purposes. The wafer 10 also includes an inactive area 47 which is positioned outside of the active component positions 12, the dummy component positions 16 and the scribe line regions. The inactive area 47 is typically arranged towards the periphery of the semiconductor wafer 10.

One or more of the composite alignment marks 14 may be positioned in one or more of the scribe line regions 13, one or more of the dummy component positions 16, one or more of the active component positions 12 and in one or more locations on the inactive portion 47 of the semiconductor wafer 10.

The composite alignment mark 14 indicates a unique orientation of the semiconductor wafer 10 and may be used for aligning the semiconductor wafer 10 during various manufacturing steps to form the devices within the wafer, to perform process control during manufacture of the wafer as well as testing of the active devices and auxiliary devices in the dummy positions 16, for aligning the wafer prior to the singulation of the wafer along the scribe line regions 13 to separate the individual semiconductor dies from the semiconductor wafer 10 and /or for removing the dies from the singulated wafer during pick and place.

During the manufacturing of a semiconductor wafer, the wafer is positioned such that it has a desired position within a tool or apparatus. An initial orientation can be performed using a mechanical alignment method, for example a flat edge or notch formed in the wafer 10 may be mechanically aligned with a flat edge or protrusion in an apparatus. Then, the wafer 10 is aligned relative to the tool using the one or more composite alignment marks 14 formed on the front surface.

Generally, semiconductor devices fabricated by carrying out a sequence of processing steps to form the devices in the wafer and by depositing a stack of layers of differing materials, for example electrically insulating, dielectric, electrically conductive layers and patterning the layers to form a metallisation structure which provides the electrically conductive redistribution structure between the outermost contact surfaces and the semiconductor devices formed within the wafer. Each of these steps and layers is typically aligned to an underlying structure or layer using alignment marks, which may be formed on the wafer itself. The tools used to fabricate the semiconductor devices visually locate the alignment marks, whereby the position of these alignment marks is programmed into the tools. These multiple structures and layers should be aligned correctly in order for the devices to operate properly. Minimising alignment errors is helpful for ensuring that devices meet performance specifications and for achieving high yield and reliability. In the final processing stages, e.g. backend processing, the wafer 10 is aligned using the composite alignment mark 14 or marks so as to allow the tool to perform process control monitoring, align the diced wafer and remove pre-selected dies from the diced wafer using pick and place processes. Typically, the composite alignment marks are located using optical methods, for example an optical microscope.

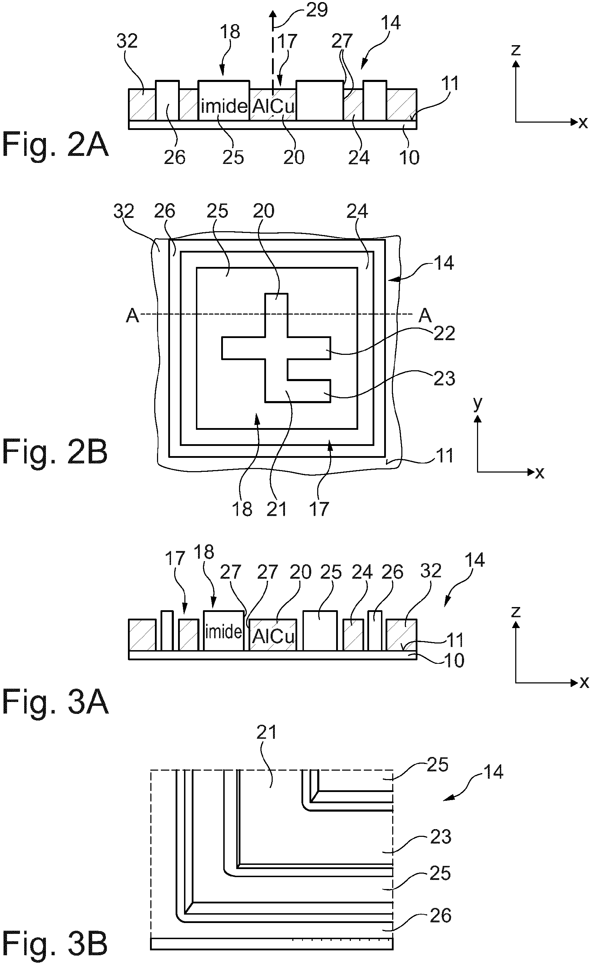

Figure 2A illustrates a cross-sectional view along the line A-A shown in figure 2B and figure 2B a plan view of a composite alignment mark 14 according to an embodiment. The composite alignment mark 14 is positioned on the front surface 11 of the semiconductor wafer 10. The composite alignment mark 14 comprises a first portion 17 which is formed of a first material and a second portion 18 which is formed of a second material which is different from the first material. The first and second portions 17, 18 are arranged laterally adjacent to one another on the front surface 11 of the wafer 10. In some embodiments, such as that illustrated in figure 2, the first portion 17 is formed of electrically conductive material such as a metal or alloy, for example an aluminium copper alloy and the second portion 18 is formed of electrically insulating material, such as polyimide.

As can be seen in the top view of figure 2B, the first portion 17 includes a first raised section 20 which has a shape which can be considered to be a 7 cross. The first raised section 20 includes a first leg 21 extending in a longitudinal or Y direction in the Cartesian coordinate system, a second leg 22 which extends substantially orthogonally to the first section 21 and in the X direction and intermediate the length of the first leg 22 to form a cross. A third leg 23 extends from distal end of the first leg 21 on one side only in the X direction and substantially parallel to the second leg 22 to form a 7 shape. The legs 21, 22, 23 of the first raised section 20may each have substantially the same width and height. The first portion 17 includes a second raised section 24 which has the form of a closed border or frame which laterally surrounds and is spaced apart from the first raised section 20. The frame may have a square or rectangular form, with sections extending in the longitudinal Y direction that are connected by sections extending in the transverse Y direction. The sections of the frame 24 have substantially the same width and height on all four sides. As can be seen in the cross-sectional view of figure 2A, the raised sections 20, 24 have side faces 27 which extend substantially perpendicularly to the front surface 11 of the wafer 10.

The second portion 18 of the composite alignment mark 14 has a third raised section 25 that fills the regions of the front surface 11 between the first and second sections 20, 24 of the first portion 17. The second portion 18 also includes a fourth section 26 having the form of a frame which laterally surrounds the frame section 24 of the first portion 17. The frame 26 also has the form of a square or rectangular frame having substantially the same width on all sides. As can be seen in the cross-sectional view figure 2A, the side faces 27 of the first portion 17 and the side faces 27 of the second portion 18 touch one another and are contiguous. In this embodiment, the second portion 18 has a height which is slightly greater than the height of the first portion 17. The first portion 17 may be formed from a metallic layer of the metallisation structure formed on the devices formed in the component positions 16 and the second portion from an electrically insulating layer of the metallisation structure formed on the devices formed in the component positions 16, such as polyimide. The frame section 26 of the second portion 18 is laterally surrounded and bordered by further regions 32 of this metallic layer.

In this embodiment, the first raised section 20 of the first portion 17 is rotationally asymmetric about an axis which extends substantially perpendicularly to the front surface 11 of the wafer as indicated by the arrow 29 extending in the Z direction. The first raised section 20 can therefore be used to indicate a unique orientation of the wafer 10. The first raised section 25 of the second portion 18 has the complementary or inverse shape of the first raised section and also has a rotationally asymmetric shape and, therefore, also indicates a unique orientation of the wafer 10. The frames provided by the first raised section 24 of the first portion 17 and the fourth raised section 26 of the second portion 18 are rotationally symmetrical. The frame sections 24, 26 may be used for height adjustment if the dimensions of the fame sections 24, 26 are known.

The first and second material of the first and second portions 17, 18 of the composite alignment mark 14 are, therefore, selected so as to have a sufficient optical contrast between one another. For example, the optical contrast in the visible wavelength range should be sufficient to allow the location of the alignment mark by eye, or light microscope. If the first portion 17 alone is to be used as an alignment mark at an earlier stage of wafer production, the optical contrast between this material and the underlying surface of the semiconductor wafer, which may be the semiconductor material of the wafer 10 or another layer formed on the semiconductor wafer 10, such as a passivation layer, are selected to have sufficient optical contract.

Figure 3A illustrates a cross sectional view of a composite alignment mark 14 according to another embodiment. Figure 3B illustrates a top view of a portion of the composite alignment mark 14 shown in figure 2B, in particular, the region between the intersection of the distal end of the first leg 21 and the third leg 23 and the surrounding fame 24. In this embodiment, the composite alignment mark 14 has the same general form as that illustrated in figure 2A. In this embodiment, however, the second portion 18 is spaced apart from the first portion 17 by a gap 28 such that the side faces 27 of the raised sections 20, 24 of the first portion 17 are spaced apart from the side faces 27 of the raised sections 25, 26 of the second portion 18.

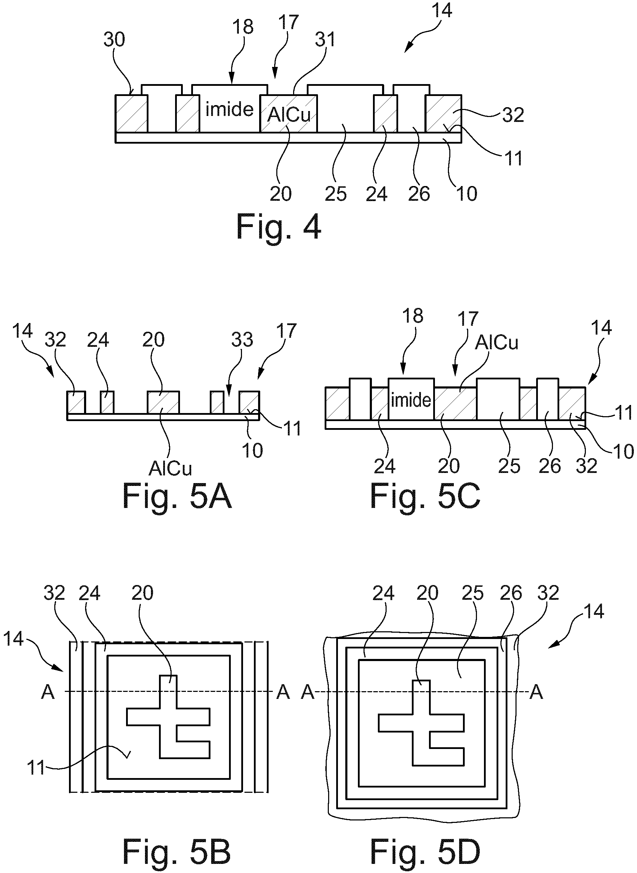

Figure 4 illustrates a cross-sectional view of a composite alignment mark 14 according to another embodiment which has the same shape general shape in the top view as illustrated in figure 2B. In this embodiment, the second portion 18 overlaps the peripheral regions 29 of the top surface 30 of the first portion 17. The central regions 31 of the upper surface 30 of the raised sections 20, 24 of the first portion 17 remain uncovered by the material of the second portion 18. The exposed regions 31 of the first portion 17 and of the second portion 18 have a shape that corresponds to the general shape of the first and second portion 17, 18 shown in figure 2B and indicate a unique orientation of the composite alignment mark 14 and of the semiconductor wafer 10.

Figure 5 illustrates the fabrication of the composite alignment mark 14 of Figure 2, whereby Figure 5A illustrates a cross-sectional view along the line A-A shown in figure 5B and figure 5B a top view after fabrication of the first portion 17 of the composite alignment mark 14. Figure 5C and figure 5D illustrates a cross-sectional view along the line A-A of figure 5D and top view, respectively, of the composite alignment mark 14 after fabrication of the second portion 18 of the composite alignment mark 14.

The first portion 17 of the composite alignment mark 14 is formed by depositing a first layer, which may be formed of one or more metallic layers, for example a layer of an aluminium copper alloy, and structuring this first layer to form the first raised section 20 and the second raised section 24 by removing portions of the first layer. The first layer may be structured by laser ablation, wet etching or plasma etching, for example. The peripheral edge regions 32 of the first layer that are positioned laterally adjacent the composite alignment mark 14 can also be seen in figures 5A and 5B. The first portion 17 of the composite alignment mark 14 has a shape which indicates a unique orientation of the semiconductor wafer since the first raised section 20 has a shape which is asymmetrical about the axis 19 which extends substantially perpendicularly to the front surface 11 of the wafer 10, for example the 7-cross shape shown in figure 2B. The first section 20 of the composite alignment mark 14 may itself be used for alignment purposes before completion of the fabrication of the composite alignment mark 14 by depositing the second portion 18.

Figures 5C and 5D illustrate that, subsequently, a second layer of a different material, for example an electrically insulating material such as polyimide, is deposited which fills the regions between the first and second sections 20, 24 of the first portion and the gap 33 between the second section 24 and the peripheral regions 32 of the surrounding regions of the first layer. This gap 33 may have a substantially uniform width and provide the frame 26 formed of the second material. The second layer may be deposited such that it covers the upper surface of the first and second sections 20, 24 and is subsequently structured by removing the portions of the second layer which are positioned on the upper surface of the first portion 17 to form the laterally separate sections 25, 26 of the second portion 18 of the composite alignment mark 14. The second layer may be structured using photolithographic techniques, for example. In some embodiments, in the composite alignment mark 14, the second layer has a height which is greater than the height of the first layer, as can be seen in the cross-sectional view of figure 5C, since it initially covered the upper surface of the first portion 17.

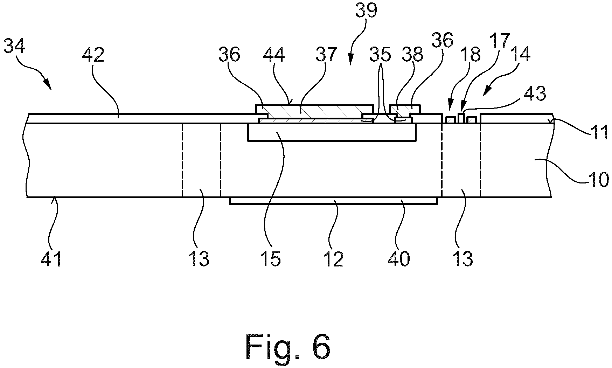

The composite alignment mark 14 may be formed from layers which form part of the active devices formed in the active component positions 12. Figure 6 illustrates a cross-sectional view showing an active component position 12 of the semiconductor wafer 10 which is laterally surrounded by scribe line regions 13 along which the wafer 10 will be diced to form a cuboid semiconductor die including an active device 15 from each component active component position 12. The first and second portions 17, 18 of the composite alignment mark 14 are formed from layers of the first metallisation structure 34 which is formed on the front surface 11 of the wafer 10. The frontside metallisation structure 34 typically includes one or more electrically conductive layers formed of a metal or alloy and one or more electrically insulating layers.

In the embodiment illustrated in figure 6, the frontside metallisation comprises a layer 35 formed of an aluminium copper alloy and a copper layer 36 which is positioned on the aluminium copper layer and which provides a source pad 37 and gate pad 38 for a vertical transistor device 39 formed in the active component position 12. A drain pad 40 is arranged on the rear surface 41 of the wafer, the rear surface 41 opposing the front surface 11. The metallisation structure 34 may include further conductive layers, for example, tungsten or a titanium or titanium nitride layers which are arranged between the aluminium copper layer 35 and the transistor device 39.

A polyimide layer 42 of the frontside metallisation structure 34 is positioned on the front surface 11 of the semiconductor wafer 10 such that it extends over peripheral regions of the portions of the aluminium copper layer 35 providing the source pad 37 and gate pad 38 and extends over the semiconductor material and over the scribe line regions 13. For semiconductor dies which are to be mounted in a source down arrangement, for example, in a can type package, the peripheral regions of the semiconductor dies, formed by the portions of the scribe line regions 13 that are not removed during dicing, are entirely covered by the polyimide layer 42. Consequently, the polyimide layer 42 extends over the entire width wₛ of the scribe line regions 13 of the semiconductor wafer 10. In figure 6, the composite alignment mark 14 is located in one of the scribe line regions 13 and is formed from the aluminium copper layer 36 and the polyimide layer 42. The outermost surface 43 of the second portion 18 of the composite alignment mark 14 is, therefore, positioned at a distance from the front surface 11 of the semiconductor wafer 10 which is less than the outermost surface 44 of the copper layer of the source pad 37 and gate pad 38. The upper surface of the first portion 17 of the composite alignment mark 14 is positioned at a distance from the front surface 11 that is less than the distance tween the upper surface 43 of the second potion 18 from the front surface 11. The composite alignment mark 14 may be located at other positions on the front surface 11, for example in a dummy component position, in an inactive region 47 or in an active component position 12.

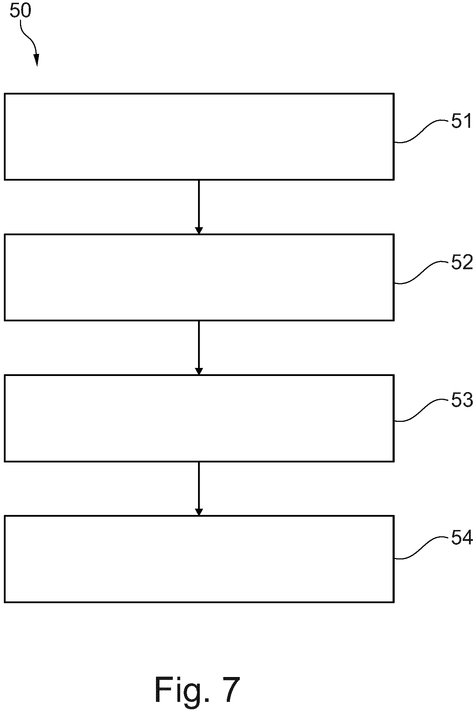

Figure 7 illustrates a flow diagram 50 of a method of fabricating a composite alignment mark. In box 51, a first layer of a first material is deposited onto a front surface of the semiconductor wafer that comprises a plurality of active component positions. In box 52, a first portion of at least one composite mask is formed in the first layer. The first portion of the at least one composite alignment mark has at least one raised section formed of the first material and has a shape which indicates a unique orientation of the wafer. The first portion may be formed from the first layer by structuring and removing regions of the first layer by laser ablation or by etching. In other embodiments the first material is selectively deposited to form the at least one raised section formed of the first material. The first and second materials should have an optical contrast that enables them to be discerned optically, for example in the visible wavelength range.

In box 53, a second layer is deposited on the first layer, whereby the second layer comprises a second material that differs from the first material. For example, the first material may be a metal or an alloy and the second material be electrically insulating material. The first and second layers may each also be formed of sublayers having different compositions, for example the first layer may be formed of two or more metallic sublayers and the second layer be formed or two or more electrically insulating sublayers.

In box 54, the second layer is structured to form a second portion of the composite alignment mark. The second portion comprises at least one raised section formed of the second material. The second layer is structured so as to expose at least part of the one or more raised sections formed of the first material in order to form the composite alignment mark comprising the first and second portions of differing materials, which are arranged laterally adjacent one another on the front surface of the wafer. This composite alignment mark indicates the unique orientation of the wafer.

In some embodiments, the first layer may be structured to form one or more contact pads in the active component positions of the semiconductor wafer, for example, a source pad and/or a gate pad for a vertical transistor device formed in the active component positions. The second layer may be further structured to expose at least regions of the gate pad and/or source pad.

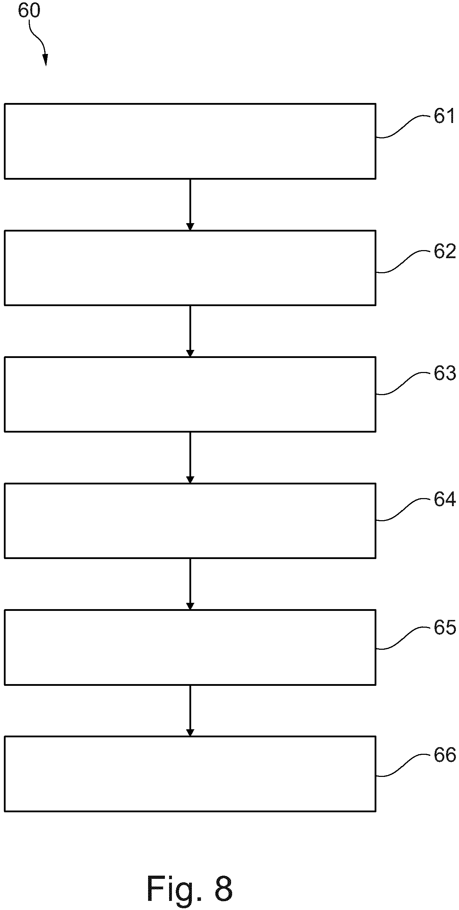

Figure 8 illustrates a flow diagram 60 of a method for fabricating a semiconductor wafer. In box 61, a first layer of a first material is deposited onto the front surface of the semiconductor wafer and a first portion of at least one composite alignment mark is formed in the first layer. One or more portions of the frontside metallisation structure for a device positioned within the active component positions of the semiconductor wafer are also formed from the first layer, for example contact pads or parts of the redistribution structure for the device. The first layer may be formed of metal or alloy or may include two or more sublayers, each sublayer being formed of metal or alloy. The first portion of each of the composite alignment marks has a shape which is capable of indicating a unique orientation of the semiconductor wafer.

In box 62, the wafer is aligned using the first portion of the at least one composite alignment mark. After alignment of the semiconductor wafer, one or more parameters of a device formed in the semiconductor wafer is tested. The device may be formed in the one of the active component positions or may be a test structure or auxiliary structure formed in the semiconductor wafer. A test or auxiliary structure may be formed in the scribe line region, an active component position, a dummy component position or an inactive portion of the semiconductor wafer.

In box 64, the method continues by depositing a second layer of a second material that is different from the first material onto the front surface of the semiconductor wafer and forming a second portion of the at least one composite alignment mark. The second layer may be formed of an electrically insulating material and deposited in the form of a closed layer which is then structured, by removing portions of the closed electrically insulating layer to expose some or all of the first portion of the at least one composite alignment mark. The second layer may also form part of the front side metallization structure formed in the active component portions and also be structured to expose one or more contact pads of the active device devices formed in the active component positions.

In box 65, the wafer is aligned using the least one composite alignment mark which is formed from the first and second portions of differing material and in box 66, a parameter of a device formed in the semiconductor wafer is tested. The device may be an active device formed in one of the active component positions or a test or auxiliary structure. The device to be tested may be formed in one of the active component positions, the scribe line region, dummy component position or an inactive portion of the semiconductor wafer. The device which is tested after formation of the second layer may be the same or different from the device which is tested after the formation of the first portion of the composite alignment mark. The first and second materials are selected so as to provide sufficient optical contrast between the first material and the semiconductor wafer and between the first and second materials.

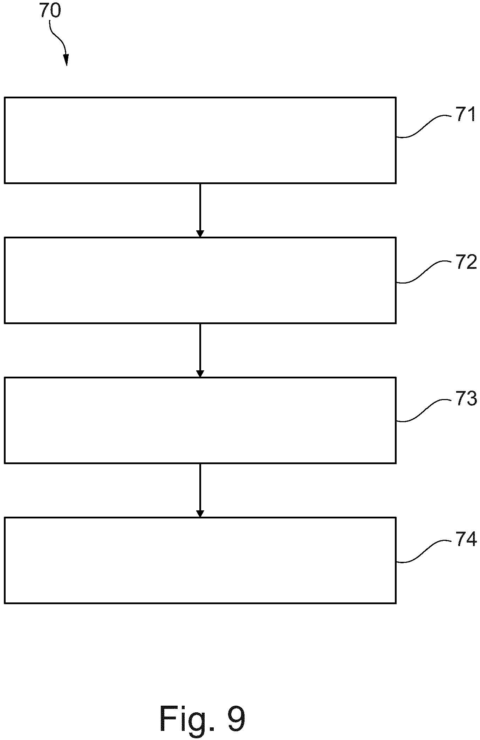

Figure 9 illustrates a flow diagram 70 of a method for fabricating a semiconductor component. in box 71, the semiconductor wafer with at least one composite alignment mark formed on its front surface is aligned using at least one of the composite alignment marks. The wafer of any one of the embodiments described herein may be used. The wafer may be fabricated using any one of the methods described herein, for example as described with reference to figures 5, 7 or 8. In box 72, the semiconductor dies are singulated from the semiconductor wafer by cutting through the wafer in the scribe line regions. in box 73, an individual die is removed from the singulated wafer and in box 74 the individual die is mounted on a support structure of a semiconductor package.

The wafer may be realigned using one or more of the composite alignment marks after singulation and before removal of the dies. Additionally, the wafer may be realigned after some of the dies have been removed from the singulated wafer. In these embodiments, one or more composite alignment marks are located in regions of the wafer that are not removed during singulation. For example, one or more composite alignment marks may be located in one or more dummy component positions that are distributed across the area of the wafer.

In some embodiments, the support structure may be a metal can and the semiconductor die provide a vertical transistor device, which has a drain contact on its rear side and a source pad and gate pad on its opposing surface front surface. The drain contact is mounted on and electrically coupled to the base of the can and the source pad and the gate pad on the opposing surface front surface are substantially coplanar with the peripheral rim of the can. In other embodiments, the support structure may be a die pad of a metallic leadframe for a leaded or leadless package, or may be a die pad having the form of an electrically conductive layer formed on a redistribution structure such as a circuit board. In other embodiments, the semiconductor die may be packaged using chip embedding techniques.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor wafer (10), comprising:
a front surface (11);
a plurality of active component positions (12);
at least one composite alignment mark (14) arranged on the front surface (11) and indicating a unique orientation of the semiconductor wafer (10);
wherein the composite alignment mark (14) comprises a first portion (17) that comprises at least one raised section (20, 24) formed of a first material and a second portion (18) that is positioned laterally adjacent the first portion (17) and that comprises at least one raised section (25, 26) formed of a second material that is different form the first material.

2. A semiconductor wafer (10) according to claim 1, wherein the first and second portions (17, 18) have complementary shapes.

3. A semiconductor wafer (10) according to claim 1 or claim 2, wherein the composite alignment mark (14) is rotationally asymmetric.

4. A semiconductor wafer (10) according to one of claims 1 to 3, wherein a first raised section (24) of the first portion (17) has the form of a closed border that laterally surrounds a second raised section (20) of the first portion (17) that is rotationally asymmetric and indicates the unique orientation of the semiconductor wafer (10).

5. A semiconductor wafer (10) according to one of claims 1 to 4, wherein the second portion (18) is contiguous with the first portion (17), or overlaps the first portion (17), or is spaced apart a distance from the first portion (17).

6. A semiconductor wafer (10) according to one of claims 1 to 5, wherein at least one composite alignment mark (14) is positioned in
an inactive portion (47) of the wafer (10) outside of the plurality of active component positions (12) and/or
in a scribe line region (13) that is adjacent one of the active component positions (12) and/or
in a dummy component position (16).

7. A semiconductor wafer (10) according to one of claims 1 to 6, wherein the first material comprises a metal or alloy.

8. A semiconductor wafer (10) according to claim 8, wherein the first material comprises Al or comprises Cu or is formed of an AlCu alloy or comprises Au, W, a W alloy, Ti or TiN.

9. A semiconductor wafer (10) according to one of claims 1 to 8, wherein the second material comprises an electrically insulating material.

10. A semiconductor wafer (10) according to claim 9, wherein the electrically insulating material comprises an imide, or an epoxy or a nitride or an oxide or a multilayer structure comprising a nitride layer and an oxide layer.

11. A semiconductor wafer (10) according to one of claims 1 to 10, wherein the active component positions (12) each comprise a transistor device and the first portion (17) Is formed in the same electrically conductive layer as a layer of the source pad (37) and/or gate pad (38) and the second portion (18) is formed in an electrically insulating layer (42) arranged on the front surface (11) of the active component positions (12) of the semiconductor wafer 10).

12. A method of fabricating a semiconductor wafer (10), comprising:
depositing a first layer of a first material onto a front surface (11) of the semiconductor wafer (10), wherein the semiconductor wafer (10) comprises a plurality of active component positions (12);
forming a first portion (179 of at least one composite alignment mark (14) in the first layer, the first portion (17) having at least one raised section (20) formed of the first material and indicating a unique orientation of the wafer (10);
depositing a second layer (42) on the first layer, the second layer comprising a second material that differs from the first material;
structuring the second layer (42) to form a second portion (18) of the composite alignment mark (14), the second portion (18) comprising at least one raised section (25) formed of the second material, and to expose at least at part of the raised section (20) formed of the first material, thus forming the composite alignment mark (14) indicating the unique orientation of the wafer.

13. A method according to claim 12, wherein the forming the first portion (17) of at least one composite alignment mark in the first layer comprises:
structuring the first layer by laser ablation to form the at least one raised section (20) formed of the first material, or
structuring the first layer by etching to form the at least one raised section (20) formed of the first material, or
selectively depositing the first material to form the at least one raised section (20) formed of the first material.

14. A method according to claim 12 or claim 13, further comprising:
further structuring the first layer to form a gate pad (38) and/or a source pad (37) in the active component positions (12) and
further structuring the second layer (42) to expose the gate pad (28) and/or source pad (37).

15. A method according to one of claims 12 to 14, further comprising:
testing one or more parameters of a device that is positioned in one of the active component positions (12) and/or testing one or more parameters of an auxiliary device (46) that is positioned in a dummy component position (16) or in a scribe line region (13).
